# EUROPÄISCHE PATENTSCHRIFT

(11) **EP 2 603 807 B1**
(45) Veröffentlichungstag und Bekanntmachung des Hinweises auf die Patenterteilung: **19.12.2018**
(21) Anmeldenummer: 11782376.5
(22) Anmeldetag: 04.08.2011
(51) Int. Cl.: G01R 31/327, H01H 47/32

(54) **VERFAHREN UND VORRICHTUNG ZUR ERMITTLUNG DES ZUSTANDS EINES ELEKTRISCH ANGESTEUERTEN VENTILS**
METHOD AND DEVICE FOR DETERMINING THE STATE OF AN ELECTRICALLY CONTROLLED VALVE
PROCÉDÉ ET DISPOSITIF DE DÉTERMINATION DE L'ÉTAT D'UNE VANNE À COMMANDE ÉLECTRIQUE

(30) Priorität: 11.08.2010 DE 102010036941
(43) Veröffentlichungstag der Anmeldung: 19.06.2013
(73) Patentinhaber: Danfoss Power Solutions GmbH & Co. OHG, 31141 Neumünster (DE)
(72) Erfinder: FINK, Sven, 25791 Linden (DE); SATERBAK, Matt, Robbinsdale, MN 55422 (US)
(74) Vertreter: Nestler, Jan Hendrik
(86) Internationale Anmeldenummer: PCT/DE2011/075186
(87) Internationale Veröffentlichungsnummer: WO 2012/041308

(56) Entgegenhaltungen:
- EP-A2- 0 400 389
- US-A- 4 970 622
- US-A1- 2004 016 461
- US-A1- 2005 180 084

## Beschreibung

Die Erfindung betrifft ein Verfahren zur Ermittlung zumindest eines Zustandskennwerts einer zumindest zeitweise und/oder zumindest teilweise mit einem zeitlich variierenden Steuersignal angesteuerten elektrischen Vorrichtung. Weiterhin betrifft die Erfindung eine elektrische Steuervorrichtung zur zumindest zeitweisen und/oder zumindest teilweisen Ermittlung zumindest eines Zustandskennwerts einer mit einem zeitlich variierenden Steuersignal angesteuerten elektrischen Vorrichtung.

Heutzutage werden unterschiedlichste Arten von elektrischen Vorrichtungen unter Verwendung von elektrischem Strom angesteuert.

Soll eine elektrische Vorrichtung beispielsweise in Abhängigkeit von bestimmten Messwerten und/oder zu unterschiedlichen Zeitpunkten einen unterschiedlichen Zustand einnehmen, so kann die Ansteuerung der elektrischen Vorrichtung unter Verwendung von zeitlich variierenden Steuersignalen erfolgen. Je nach Art des angelegten Steuersignals nimmt dann die elektrische Vorrichtung in der Regel einen bestimmten Zustand ein. Dabei ist es möglich, dass zwischen dem Anlegen eines für einen bestimmten Zustand der elektrischen Vorrichtung erforderlichen oder sinnvollen Steuerwerts und dem schlussendlichen Einnehmen des entsprechenden Zustands eine gewisse Zeitdauer liegt (eine sogenannte Zeitverzögerung). Die Größe der Zeitverzögerung kann dabei nicht nur von Art und Aufbau der elektrischen Vorrichtung abhängen, sondern insbesondere auch von der erforderlichen Größe der Änderung des Zustands der elektrischen Vorrichtung.

Ein Problem bei einer solchen Ansteuerung von elektrischen Vorrichtungen liegt insbesondere darin, dass man wissen will, wann (und gegebenenfalls ob) die elektrische Vorrichtung den gewünschten Zustand einnimmt. So kann es beispielsweise vorkommen, dass beispielsweise aufgrund eines technischen Defekts oder aufgrund einer ungewöhnlich großen Gegenkraft auf die elektrische Vorrichtung, die elektrische Vorrichtung den gewünschten Zustand gar nicht einnehmen kann. Aber selbst dann, wenn die elektrische Vorrichtung zu einem bestimmten Zeitpunkt schlussendlich den gewünschten Zustand einnimmt, kann die Zeitverzögerung unterschiedlich groß sein. Bei vielen Anwendungen ist es jedoch erwünscht, eine bestimmte, definierte Verzögerungszeit zu haben (bzw. nicht zu überschreiten).

Eine einfache Ansteuerung einer elektrischen Vorrichtung mit einem zeitlich variierenden Steuersignal alleine erweist sich somit in vielen Fällen als nicht ausreichend.

Eine Möglichkeit, um Informationen über den aktuellen Zustand der elektrischen Vorrichtung besteht darin, dass spezielle Messsensoren vorgesehen werden, die den aktuellen Zustand der elektrischen Vorrichtung an eine Steuereinheit melden. Dieses Vorgehen ist jedoch in vielen Fällen problematisch, da die Messsensoren häufiger einen zum Teil erheblichen Kostenaufwand bedeuten. Weiterhin ist aufgrund beengter Bauraumverhältnisse der Einbau eines Messsensors oftmals nicht oder nur äußerst problematisch möglich.

Eine weitere grundsätzliche Möglichkeit besteht in vielen Fällen darin, dass man das zur Ansteuerung der elektrischen Vorrichtung verwendete zeitlich variable Steuersignal selbst für die zumindest näherungsweise Erfassung des Zustands der elektrischen Vorrichtung verwendet (und somit die elektrische Vorrichtung selbst quasi als "intrinsischen Messsensor" nutzt). Hier kann die Messvorrichtung (beziehungsweise Teile davon) gewissermaßen von besonders unerwünschten (beispielsweise besonders beengten) Bereichen in, in Bezug auf den Bauraum weniger kritische Bereiche verlagert werden. Zum Teil kann bei einem derartigen Vorgehen auch auf bereits vorhandene, bzw. ohnehin vorzusehende Komponenten zurückgegriffen werden was die Kosten verringern kann.

Ein Beispiel unter vielen für derartige elektrische Vorrichtungen sind elektrische Aktuatoren für Ventile, wie sie beispielsweise für Motoren und Pumpen, insbesondere für Verbrennungsmotoren, Hydraulikmotoren, Kompressoren und Hydraulikpumpen, oder für Schaltaufgaben in unterschiedlichen Hydrauliksystemen bzw. fluidleitenden Systemen verwendet werden. Bei solchen technischen Vorrichtungen möchte man nicht nur unterschiedliche Schaltzustände der mit Hilfe der Aktuatoren angesteuerten Ventile ansteuern, sondern insbesondere auch eine Rückmeldung darüber erhalten, ob tatsächlich ein Schaltvorgang erfolgt ist und vorzugsweise auch darüber, wann die Umschaltung erfolgt (insbesondere im Wesentlichen abgeschlossen) ist. Unter Kenntnis derartiger Größen können bessere Ansteuerungsalgorithmen genutzt werden und geeignete Maßnahmen im Fall von Störungen durchgeführt werden.

Vorschläge für elektrische Aktuatoren, deren Position durch "intrinsische" Sensoren gemessen werden können, wurden bereits gemacht.

So wurde beispielsweise von M. F. Rahman, N. C. Cheung und K. W. Lim in der Veröffentlichung "Position Estimation in Solenoid Actuators" in IEEE Transactions on Industry Applications, Vol. 32, No. 3, Mai/Juni 1996 ein Verfahren zur Abschätzung der Position eines magnetischen Ankers in einer Spule vorgeschlagen. Die Autoren beschreiben dabei, dass sich die Induktivität der Spule in Abhängigkeit von der Position des darin beweglich angeordneten magnetischen Ankers ändert und zunächst zunimmt. Ab einem bestimmten Punkt wiederum fällt die Induktivität aufgrund von Sättigung wieder ab. Basierend auf einer Messung des angelegten, elektrischen Stroms schließen die Autoren somit auf die Position des magnetischen Ankers innerhalb der Spule. Problematisch ist bei dem dort beschriebenen Verfahren jedoch, dass das vorgeschlagene Messverfahren selbst nach Aussage der Autoren lediglich für quasi-stationäre Systeme brauchbare Ergebnisse liefert. Diese Vernachlässigung ist jedoch für viele technische Systeme nicht gegeben.

Ein weiterer Vorschlag wurde beispielsweise in der US-amerikanischen Patentanmeldung US 2008/0143346 A1 gemacht. Hier wird basierend auf dem Steigungsverhalten des an einem elektromagnetischen Aktuator angelegten elektrischen Stroms auf die Position des Aktuators geschlossen. Das dort beschriebene Verfahren setzt jedoch die Kenntnis von dezidierten Ausgangspositionen voraus. Ausgehend von diesen Positionen wird die Positionsänderung gewissermaßen "aufintegriert". Störungen, beispielsweise in Form eines nicht mehr vollständig öffnenden bzw. schließenden Ventils können mit den vorgeschlagenen Verfahren praktisch nicht erkannt werden. Darüber hinaus ist das dort beschriebene Verfahren ebenfalls nur für quasi-stationäre Systeme geeignet.

Weitere Beispiele werden in US 4 970 622 A, US 2004/016461 A1, EP 0 400 389 A2 und 2005/180084 A1 offenbart.

Es besteht somit nach wie vor Bedarf an einem verbesserten Verfahren zur Bestimmung eines Zustands einer durch ein zeitlich variierendes Steuersignal angesteuerten elektrischen Vorrichtung, insbesondere hinsichtlich der Position eines elektrisch angesteuerten Aktuators. In analoger Weise besteht auch ein Bedarf an einer verbesserten Steuervorrichtung für einen Aktuator. Die Aufgabe der Erfindung ist es somit, ein gegenüber dem Stand der Technik verbessertes Verfahren zur Ermittlung zumindest eines Zustandskennwerts einer zumindest zeitweise und/oder zumindest teilweise mit einem zeitlich variierenden Steuersignal angesteuerten elektrischen Vorrichtung vorzuschlagen. Weiterhin besteht die Aufgabe der Erfindung darin, eine gegenüber dem Stand der Technik verbesserte elektrische Steuervorrichtung zur zumindest zeitweisen und/oder zumindest teilweisen Ermittlung zumindest eines Zustandskennwerts einer mit einem zeitlich variierenden Steuersignal angesteuerten elektrischen Vorrichtung vorzuschlagen.

Die Erfindung löst die Aufgabe.

Es wird vorgeschlagen, ein Verfahren zur Ermittlung zumindest eines Zustandskennwerts einer zumindest zeitweise und/oder zumindest teilweise mit einem zeitlich variierenden Steuersignal angesteuerten elektrischen Vorrichtung gemäß Anspruch 1 durchzuführen. Bei dem zu ermittelnden Zustandskennwert kann es sich um einen beliebigen Zustandskennwert handeln, und zwar insbesondere um einen unmittelbaren Zustandskennwert (also einem Zustandskennwert, der die elektrische Vorrichtung unmittelbar betrifft). Beispielsweise kann es sich bei einem derartigen unmittelbaren Zustandskennwert um einen elektrischen Zustand der elektrischen Vorrichtung (Stromstärke, Induktivität, Temperatur und dergleichen) handeln. Es kann sich aber auch um einen mittelbaren Zustand (also einen Zustandskennwert, der die elektrische Vorrichtung nur mittelbar betrifft), wie beispielsweise die Position, die Geschwindigkeit, den Fluiddurchsatz und dergleichen einer mit der elektrischen Vorrichtung verbundenen beispielsweise mechanischen Baugruppe (z. Bsp. ein Ventil) handeln. Bei der elektrischen Vorrichtung selbst kann es sich ebenfalls um eine im Wesentlichen beliebige elektrische Vorrichtung handeln. Die elektrische Vorrichtung wiederum kann "in Alleinstellung" betrieben werden, oder (auch integral) mit anderen, beispielsweise mechanischen Baugruppen verbunden sein. Dies schließt insbesondere auch Fälle ein, in denen die elektrische Vorrichtung mit bestimmten mechanischen Bauteilen eine integrale funktionale Einheit bildet, wie beispielsweise ein in einem Magnetfeld einer elektrischen Spule beweglich angeordneter magnetischer Anker. Bei dem zeitlich variierenden Steuersignal kann es sich ebenfalls um ein im Wesentlichen beliebiges elektrisches Signal handeln, bei dem es sich nicht um eine (dauerhafte) elektrische Gleichspannung handelt. Typischerweise weist das zeitlich variierende Steuersignal eine Frequenz auf, die zumindest zeitweise und/oder zumindest teilweise > 0,1 Hz, > 0,5 Hz, > 1 Hz, > 2 Hz, > 5 Hz, > 10 Hz, > 20 Hz, > 50 Hz, > 100 Hz, > 200 Hz, > 500 Hz, > 1 kHz, > 2 kHz, > 3 kHz, > 4 kHz, > 6 kHz und/oder > 6 kHz Ist (wobei in allen genannten Fällen auch der Wert selbst mit eingeschlossen sein kann). Unter einem zeitlich variierenden Steuersignal sind dabei ausdrücklich nicht nur "reine" Wechselspannungen zu verstehen, sondern insbesondere auch elektrische Spannungsmuster mit einem (gegebenenfalls auch hohen) Gleichspannungsanteil, der von einem Wechselspannungsanteil überlagert ist. Der Vollständigkeit halber sollte darauf hingewiesen werden, dass sich die Wechselspannung (bzw. der Wechselspannungsanteil) durchaus von Amplitude zu Amplitude hinsichtlich ihrer Höhe, ihre Länge, ihrer Frequenz und/oder ihrer Signalform sich verändern kann. Das zeitlich variierende Steuersignal kann dabei in beliebiger Weise die elektrische Vorrichtung (zumindest zeitweise und/oder zumindest teilweise) unmittelbar und/oder (zumindest zeitweise und/oder zumindest teilweise) mittelbar ansteuern. Es ist also denkbar, dass es sich bei dem Steuersignal um einen Strom handelt, der beispielsweise in einer elektrischen Spule fließt. Ebenso kann es sich bei dem Steuersignal jedoch auch um einen Strom handeln, der beispielsweise als Eingangssignal für eine Schaltungslogik, als Eingangssignal für einen (Leistungs-)Transistor (oder für ein ähnliches elektronisches Schaltbauteil) verwendet wird. Die Erfinder haben nun zu ihrer eigenen Überraschung festgestellt, dass es auf besonders einfache Weise möglich ist, zumindest manche der Zustandskennwerte mit erstaunlich hoher Genauigkeit ermitteln zu können, wenn hierzu zumindest zeitweise und/oder zumindest teilweise die Frequenz und/oder das Schaltverhältnis des zeitlich variierenden Steuersignals herangezogen wird. Unter einer Frequenz des zeitlich variierenden Steuersignals ist nicht nur eine volle Zykluslänge eines im Wesentlichen periodischen Signals zu verstehen. Insbesondere kann unter einer Frequenz auch der Abstand zwischen zwei (oder mehreren) Nullpunktdurchgängen bzw. besonders ausgezeichneten Punkten der Steuersignalkurve verstanden werden. Auch ist es möglich, dass das Steuersignal beispielsweise auch zwei (gegebenenfalls auch mehrere) besonders ausgezeichnete Schaltzustände aufweist und das Verhältnis (beispielsweise das zeitliche Verhältnis) der beiden (bzw. mehreren) ausgezeichneten Schaltzustände zueinander zur Ermittlung des Zustandskennwerts herangezogen wird. Dabei kann es sich insbesondere um ein so genanntes "Duty Cycle" eines pulsweitenmodulierten Signals handeln.

Bevorzugt ist es, wenn es sich bei dem zeitlich variierenden Steuersignals zumindest zeitweise und/oder zumindest teilweise um ein pulsartiges Steuersignal und/oder zumindest zeitweise und/oder zumindest teilweise um ein zyklisches Steuersignal handelt. Insbesondere kann es sich zumindest zeitweise und/oder zumindest teilweise um ein pulsweitenmodulationsartiges Steuersignal und/oder zumindest zeitweise und/oder zumindest teilweise um ein rechteckartiges Steuersignal handeln. Unter einem pulsartigem Steuersignal ist insbesondere ein Signal zu verstehen, welches vornehmlich lediglich Ein- und Ausschaltzustände aufweist (also gewissermaßen ein binäres Signal). Möglich ist es selbstverständlich auch, dass "Zwischenstufen" und/oder auch negative Spannungswerte vorgesehen werden können. Auch ist es möglich, das Steuersignal mit einem (gegebenenfalls mit einer anderen Frequenz variierenden) Gleichspannungsanteil zu überlagern. Unter "pulsartig" ist nicht nur das Vorkommen von zeitlich kurzen Pulsen zu verstehen; vielmehr können auch relativ lang andauernde Pulse (insbesondere im Verhältnis zu den "Auszeiten" des Steuersignals) vorgesehen werden. Unter einem zyklischen Steuersignal ist nicht nur ein Signal zu verstehen, welche sich beispielsweise nach Ablauf einer Periode oder einer gewissen Zeit mehr oder weniger gleichartig wiederholt. Vielmehr sind hierunter auch Signale zu verstehen, die sich in "qualitativer Hinsicht" wiederholen. Wenn beispielsweise das Steuersignal aus einer Abfolge von rechteckartigen Pulsen mit unterschiedlicher Frequenz und unterschiedlicher Breite besteht, so kann dieses gegebenenfalls als zyklisches Steuersignal im Sinne dieser Beschreibung aufgefasst werden. Bevorzugt kann es sich um ein pulsweitenmodulationsartiges Steuersignal handeln. Hierunter sind nicht nur pulsweitenmodulierte Steuersignale im strengen Sinne zu verstehen, bei denen die Frequenz üblicherweise konstant bleibt, und sich lediglich das Schaltverhältnis der "An-Phasen" sowie der "Aus-Phasen" zueinander (sogenannter "Duty-Cycle") verändert. Vielmehr ist es im Gegenteil sogar bevorzugt, dass zusätzlich zu (gegebenenfalls auch anstatt) einer derartigen Veränderung des Duty-Cycles eine Veränderung der Frequenz auftreten kann. Bevorzugt ist es ebenfalls, wenn es sich zusätzlich oder alternativ um ein rechteckartiges Steuersignal handelt. Es sollte darauf hingewiesen werden, dass die genannten Steuersignale nicht notwendigerweise in ihrer streng mathematischen Form vorliegen müssen. Vielmehr wird es in aller Regel aufgrund von gewissen Bauteileinflüssen zu einer gewissen Signalverfälschung kommen. Beispielsweise werden Einschaltflanken eines rechteckigen Steuersignals aufgrund von Induktivitäten in der Regel zu einer asymptotischen Einschaltkurve verformt werden. Diese und andere Effekte können selbstverständlich auch bei Ausschaltflanken und sonstigen Signalcharakteristika zu gewissen Verformungen des Signals führen.

Weiterhin ist es bevorzugt, wenn es sich bei der elektrischen Vorrichtung zumindest zeitweise und/oder zumindest teilweise um eine, eine Induktionseinrichtung aufweisende elektrische Vorrichtung handelt, insbesondere um eine Elektromotoreinrichtung, um eine elektrische Spuleneinrichtung und/oder um eine Aktuatoreinrichtung, bevorzugt um eine Aktuatoreinrichtung für eine Ventileinrichtung, handelt. Erste Versuche haben ergeben, dass sich derartige elektrische Vorrichtungen besonders für die Verwendung im Zusammenhang mit den vorgeschlagenen Verfahren eignen. Darüber hinaus liegt bei derartigen elektrischen Vorrichtungen oftmals ein Platzproblem vor, sodass es besonders schwierig - wenn nicht sogar nahezu unmöglich - ist, bei diesen elektrischen Vorrichtungen eine zusätzliche Messsensorik vorzusehen. Auch insofern erweist sich die Verwendung des vorgeschlagenen Verfahrens als besonders vorteilhaft.

Insbesondere in diesem Fall (aber nicht notwendigerweise auf diesen beschränkt) ist es vorteilhaft, wenn die elektrische Vorrichtung zumindest zeitweise und/oder zumindest bereichsweise nicht-quasi-stationär und/oder nicht-stationär betrieben wird. Wie bereits einleitend erwähnt sind im Stand der Technik bekannte Verfahren in der Regel auf den Einsatz bei quasistationären Systemen beschränkt. Gerade bei sich schnell bewegenden Systemen (also nicht-quasi-stationär betriebenen Systemen) herrscht aber oftmals ein besonders großer Bedarf, belastbare Messungen bestimmter Zustandskennwerte zu erhalten. Denn nämlich gerade dann, wenn eine sich schnell bewegende/sich schnell verändernde technische Vorrichtung angesteuert werden soll, ist es in der Regel erforderlich, beispielsweise aus Effizienzgründen, eine zum Beispiel besonders genaue zeitliche Ansteuerung vorzunehmen. Für eine derartige, besonders genaue zeitliche Ansteuerung müssen jedoch in der Regel entsprechend schnelle und genaue Messwerte vorliegen.

Weiterhin ist es von Vorteil, wenn bei dem vorgeschlagenen Verfahren der zumindest eine Zustandskennwert zumindest zeitweise und/oder zumindest teilweise ein Maß für eine Position von zumindest Teilen der elektrischen Vorrichtung, zumindest zeitweise und/oder zumindest teilweise ein Maß für das Erreichen bestimmter, insbesondere ausgezeichneter Positionen von zumindest Teilen der elektrischen Vorrichtung, zumindest zeitweise und/oder zumindest teilweise ein Maß für die Geschwindigkeit von zumindest Teilen der elektrischen Vorrichtung und/oder zumindest zeitweise und/oder zumindest teilweise ein Maß für das Eintreten zumindest eines Fehlerereignisses darstellt. Gerade die genannten Messwerte sind für einen sicheren, effizienten und verschleißarmen Betrieb von technischen Vorrichtungen (insbesondere von sich schnell verändernden technischen Vorrichtungen) besonders sinnvoll bzw. hilfreich. Im Zusammenhang mit einem Aktuator für ein Ventil kann es sich beispielsweise um einen (im Wesentlichen) voll geöffneten Zustand, einen (im Wesentlichen) voll geschlossenen Zustand, einen dazwischen liegenden Zustand des Ventils und dergleichen handeln. Ein Fehlerereignis kann beispielsweise dann vorliegen, wenn das Ventil nicht vollständig geöffnet bzw. geschlossen werden kann.

Weiterhin ist es von Vorteil, wenn im Zusammenhang mit dem vorgeschlagenen Verfahren die elektrische Vorrichtung zumindest zeitweise und/oder zumindest teilweise mit einem Maximalstrombegrenzungsverfahren angesteuert wird. Der Begriff "Ansteuern" umfasst dabei in diesem Zusammenhang nicht notwendigerweise nur die strenge Definition des Begriffs (also die Bedeutung, dass eine Vorrichtung ohne Rückkopplung oder dergleichen angesteuert wird), sondern umfasst gegebenenfalls auch Rückkopplungsverfahren, das Einfließenlassen von Messwerten und dergleichen (was üblicherweise eher als "Regeln" bezeichnet wird. Wenn also aufgrund des Steuersignals ein gewisser maximaler Strom überschritten wird (bzw. droht, überschritten zu werden), so wird die Stärke des Steuersignals verringert oder bevorzugt für eine gewisse Zeitdauer abgeschaltet (führt in der Regel zur sogenannten Pulsweitenmodulation). Ein derartiges Ansteuerverfahren eignet sich insbesondere für elektrische Vorrichtungen, die gewisse "Zeitverzögerungseffekte" zeigen, wie insbesondere elektrische Vorrichtungen mit Induktivitäten, insbesondere Vorrichtungen mit größeren Induktivitäten, wie beispielsweise elektrische Spulen und dergleichen. Derartige Pulsweitenmodulationsverfahren für die Ansteuerung von induktiven elektrischen Vorrichtungen sind als solche bereits im Stand der Technik bekannt. Besonders vorteilhaft ist es jedoch, wenn das auf einer solchen Maximalstrombegrenzung beruhende Schaltverhalten zumindest zeitweise und/oder zumindest teilweise zur Ermittlung zumindest eines Zustandskennwerts einer elektrischen Vorrichtung herangezogen wird. Eine Maximalstrombegrenzung ist im Übrigen häufig ohnehin erforderlich, da insbesondere bei Induktivitäten oftmals eine Ansteuerung mit einer elektrischen Spannung erfolgt, die aufgrund des üblicherweise niedrigen Ohmschen Widerstands von induktiven elektrischen Einrichtungen schlussendlich zu einem zu hohen Strom (der beispielsweise eine Beschädigung der elektrischen Vorrichtung zur Folge haben könnte) führen würde. Die Ansteuerung mit einer derartigen, "zu hohen" Spannung erfolgt, um die induktive elektrische Einrichtung besonders schnell in ihren "maximal eingeschalteten" Zustand zu bringen. Ein weiterer Vorteil des vorgeschlagenen Verfahrens besteht weiterhin darin, dass es üblicherweise keine (oder allenfalls eine relativ geringe) Temperaturabhängigkeit, insbesondere von der Temperatur der elektrischen Einrichtung, aufweist. Wenn beispielsweise eine elektrische Spule als elektrische Einrichtung verwendet wird, so erhitzt sich diese im Betrieb oftmals merklich. Eine derartige Erwärmung kann einen Einfluss auf (beispielsweise) eine elektrische Widerstandsmessung der elektrischen Spule haben. Ein derartiger Einfluss kann mit dem vorgeschlagenen Verfahren beseitigt beziehungsweise verringert werden.

Insbesondere ist es möglich, das Maximalstrombegrenzungsverfahren unter Verwendung eines softwaregesteuerten Komparators zu realisieren. Ein derartiger softwaregesteuerter Komparator kann aber auch ganz allgemein für andere Aufgaben im Rahmen des Verfahrens verwendet werden. Insbesondere ist es möglich, dass beim softwaregesteuerten Komparator die zeitliche Veränderung des zeitlich variablen Steuersignals direkt im Komparator (beispielsweise in einem Mikrocontroller oder einem Einplatinen-Computer) erfolgt. Hierzu kann ein Analog-Digital-Wandler (ADC) verwendet werden, der oftmals ohnehin im Mikrocontroller (oder einer ähnlich gearteten Vorrichtung) zur Verfügung steht. Hierdurch kann sich nicht nur ein Vorteil hinsichtlich der Kosten und/oder des Bauraums ergeben. Vielmehr kann durch die Verlagerung der Messung in die Steuereinheit selbst eine größere Anzahl an Messwerten erfasst werden, die dann für Diagnosezwecke zur Verfügung stehen. Hierdurch ist es möglich, genauere Ausgangssignale, insbesondere ein genaueres Steuersignal zur Verfügung stellen zu können. Umgedreht kann es jedoch zum Teil auch von Vorteil sein, den Komparator als "klassische" Hardwarelösung zu realisieren. Derartige Hardware steht kostengünstig zur Verfügung und weist darüber hinaus oftmals eine hohe Geschwindigkeit auf. Weiterhin ist es möglich, im Falle einer externen Realisierung des Komparators die Rechenkapazität der Steuerschaltung und/oder sonstiger Komponenten geringer ausfallen lassen zu können, sodass insgesamt gegebenenfalls Kosten gespart und eventuell auch die Rechengenauigkeit erhöht werden können.

Vorteilhaft ist es weiterhin, wenn bei dem Verfahren zumindest eine mit dem zeitlich variierenden Steuersignal angesteuerte elektrische Vorrichtung zumindest zeitweise und/oder zumindest bereichsweise für eine zumindest teilweise elektrisch kommutierte Hydraulikpumpe und/oder für einen zumindest teilweise elektrisch kommutierten Hydraulikmotor verwendet wird. Derartige, elektrisch kommutierte Hydraulikpumpen/elektrisch kommutierte Hydraulikmotoren stellen eine relativ neue, jedoch vielversprechende Bauweise von Hydraulikpumpen bzw. Hydraulikmotoren dar. Solche elektrisch kommutierte Hydraulikpumpen/Hydraulikmotoren sind auch unter den englischen Begriffen "Digital Displacement Pump" und "Synthetically Commutated Hydraulic Pump" bekannt. Derartige Pumpen sind beispielsweise in GB 0 494 236 B1 und WO 91/05163 A1 beschrieben. Gerade bei derartigen Pumpen/Motoren ist es für die Funktionsweise derselben praktisch unabdingbar, dass elektrisch ansteuerbare Fluidventile (Einlassventile und/oder Auslassventile) vorgesehen werden, die einerseits sehr große Fluiddurchlassquerschnitte aufweisen, und andererseits besonders schnell und zeitlich exakt geschaltet werden können. In diesem Zusammenhang ist es auch möglich, dass die Ventile einem gewissen Verschleiß bzw. Alterungsverhalten (gegebenenfalls auch aufgrund externer Umstände) unterliegen. Dementsprechend kann sich das zeitliche Schließverhalten eines elektrisch angesteuerten Ventils auch mit der Zeit in einem bestimmten Bereich ändern. Wenn nun das Schaltverhalten unter Verwendung des vorliegend vorgeschlagenen Verfahrens gemessen werden kann, kann eine Änderung des Ventils bei folgenden Ansteuerimpulsen berücksichtigt werden. Auf diese Weise ist es möglich, auf einfache und unaufwändige Weise eine elektrisch kommutierte Hydraulikpumpe/einen elektrische kommutieren Hydraulikmotor zur Verfügung zu stellen, der auch über lange Zeiträume hinweg ein besonders gutes und exaktes Pump- bzw. Antriebsverhalten aufweist.

Vorteilhaft ist es weiterhin, wenn bei dem vorgeschlagenen Verfahren der zumindest eine Zustandskennwert zumindest zeitweise und/oder zumindest teilweise durch eine Messung des Absolutwerts der Schaltfrequenz des zeitlich variierenden Steuersignals und/oder zumindest zeitweise und/oder zumindest teilweise durch eine Messung einer Änderung der Schaltfrequenz des zeitlichen variierenden Steuersignals und/oder zumindest zeitweise und/oder zumindest teilweise durch eine Messung des Absolutwerts des Schaltverhältnisses des zeitlich variierenden Steuersignals und/oder zumindest zeitweise und/oder zumindest teilweise durch eine Messung einer Änderung des Schaltverhältnisses des zeitlich variierenden Steuersignals ermittelt wird. Erste Versuche haben ergeben, dass unter Verwendung derartiger Werte besonders aussagekräftige und genaue Zustandskennwerte ermittelt werden können.

Weiterhin wird eine elektrische Vorrichtung zur zumindest zeitweisen und/oder zumindest teilweisen Ermittlung zumindest eines Zustandskennwerts einer mit einem zeitlich variierenden Steuersignal angesteuerten elektrischen Vorrichtung gemäß Anspruch 9 vorgeschlagen. Die elektrische Steuervorrichtung weist dann die bereits beschriebenen Vorteile und Eigenschaften in analoger Weise auf. Insbesondere ist es auch möglich, die elektrische Steuervorrichtung im Sinne der vorherigen Beschreibung geeignet weiterzubilden.

Insbesondere ist es möglich, dass die elektrische Steuervorrichtung zumindest teilweise als elektronische Steuervorrichtung, insbesondere zumindest teilweise als programmgesteuerte Computereinrichtung ausgebildet ist. Hierbei kann es sich um "klassische" Computer handeln, wie insbesondere PCs, Workstations und dergleichen. Möglich - und vorteilhaft - ist es jedoch, wenn diese zumindest teilweise als sogenannte elektronische Mikrocontroller und/oder als Einplatinen-Computer ausgebildet sind. Umgekehrt kann es sich jedoch auch als vorteilhaft erweisen, wenn auf programmtechnisch gesteuerte Einrichtungen (weitgehend beziehungsweise zumindest im Wesentlichen vollständig) verzichtet wird. So haben erste Versuche ergeben, dass sich zumindest bei manchen Anforderungen dadurch bessere, schnellere und/oder kostengünstigere Aufbauten ergeben können.

Weiterhin wird vorgeschlagen, eine elektrisch kommutierte Hydraulikpumpe und/oder einen elektrisch kommutierten Hydraulikmotor zumindest zeitweise und/oder zumindest teilweise unter Verwendung des vorab beschriebenen Verfahrens anzusteuern. Zusätzlich oder alternativ wird vorgeschlagen, eine elektrisch kommutierte Hydraulikpumpe und/oder eine elektrisch kommutierten Hydraulikmotor derart auszubilden, dass diese bzw. dieser zumindest eine elektrische Steuervorrichtung vom vorab beschriebenen Typ aufweist. Die resultierende elektrisch kommutierte Hydraulikpumpe bzw. der elektrisch kommutierte Hydraulikmotor weist dann die bereits vorab beschriebenen Vorteile und Eigenschaften in analoger Weise auf. Auch ist es möglich, die Hydraulikpumpe/den Hydraulikmotor in geeigneter Weise im Sinne der obigen Beschreibung weiterzubilden. Lediglich der Vollständigkeit halber wird erwähnt, dass es durchaus auch möglich ist, dass eine elektrisch kommutierte Hydraulikpumpe bzw. ein elektrisch kommutierter Hydraulikmotor derart ausgebildet werden kann, dass diese(r) gleichzeitig als elektrisch kommutierter Hydraulikmotor bzw. als elektrisch kommutierte Hydraulikpumpe fungieren kann. Dies gilt im Übrigen auch für elektrisch kommutierte Hydraulikpumpen/elektrisch kommutierte Hydraulikmotoren, wie sie im Zusammenhang mit der Beschreibung des Verfahrens bereits erwähnt wurden.

Im Folgenden wird die Erfindung anhand vorteilhafter Ausführungsbeispiele und unter Bezugnahme auf die beigefügte Zeichnung näher erläutert. Es zeigen:
- Fig. 1: : ein erstes Ausführungsbeispiel einer zur Durchführung des Verfahrens geeigneten Vorrichtung in einem schematischen Schaltplan;
- Fig. 2:: ein zweites Ausführungsbeispiel einer für die Durchführung des Verfahrens geeigneten Vorrichtung in einem schematischen Schaltplan;
- Fig. 3:: ein drittes Ausführungsbeispiel einer für die Durchführung des Verfahrens geeigneten Vorrichtung in einem schematischen Schaltplan;
- Fig. 4:: Messergebnisse während des Schließvorgangs eines elektromagnetisch arbeitenden Aktuators;
- Fig. 5:: eine schematische Darstellung einer möglichen Bauform einer elektrisch kommutierten Hydraulikpumpe;
- Fig. 6:: einen schematischen Ablaufplan eines Verfahrens zur Ermittlung des Schließverhaltens eines Ventils.

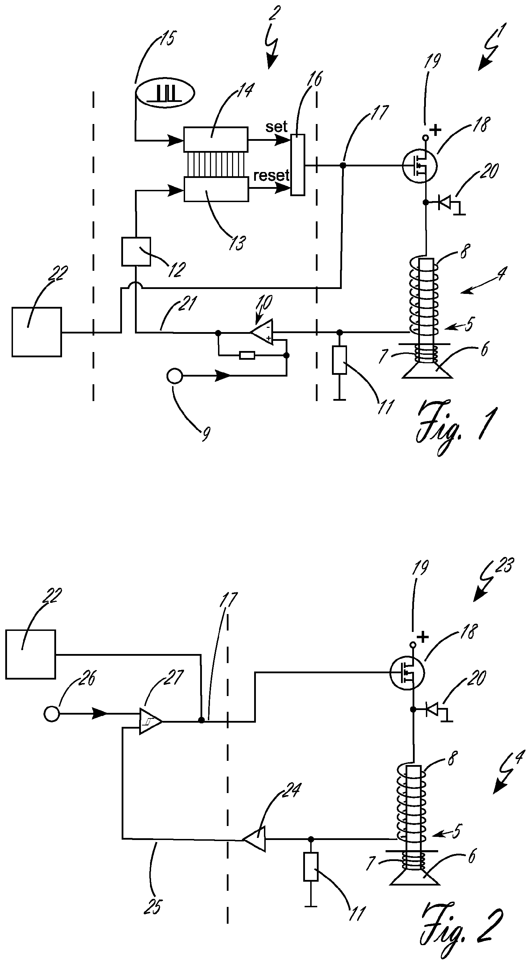

In Fig. 1 ist in einem schematischen Schaltplan eine erste mögliche Schaltungsanordnung 1 einer Steuereinheit 2 zur Ansteuerung einer Ventileinheit 4 dargestellt. Die Ventileinheit 4 weist im vorliegend dargestellten Ausführungsbeispiel einen Aktuator 5 (im vorliegenden Ausführungsbeispiel im Wesentlichen aus einer elektrischen Spule 8 gebildet) mit einem Ventilkörper 6 auf. Im vorliegend dargestellten Ausführungsbeispiel bewirkt der Aktuator 5 beim Einbringen eines elektrischen Stroms in die elektrische Spule 8 ein nach oben bewegen des Ventilkörpers 6 (sodass beispielsweise der Ventilkopf mit einem Ventilsitz in Kontakt kommt und die Ventileinheit 4 dementsprechend geschlossen wird). Wird die elektrische Spule 8 dagegen von keinem elektrischen Strom durchströmt, so bewirkt eine im vorliegenden Ausführungsbeispiel vorgesehene Rückstellfeder 7 eine Rückbewegung des Ventilkörpers 6. Selbstverständlich kann der Ventilkörper 6 auch durch externe Kräfte (beispielsweise durch eine Druckdifferenz am Ventilkopf) oder dergleichen wieder geöffnet werden.

Das eigentliche Ein- beziehungsweise Ausschalten des Aktuators 5 (und damit die Bewegung der Ventileinheit 4 bzw. des Ventilkörpers 6) wird durch Anlegen eines Eingangssignals am Signaleingang 9 initiiert. Das am Signaleingang 9 angelegte Eingangssignal bewirkt dabei - je nach angelegter Spannung - einen entsprechenden Strom in der elektrischen Spule 8. Durch eine geeignete Schaltungslogik wird jedoch ein Übersteuern der elektrischen Spule 8 verhindert, sodass diese unter normalen Bedingungen selbst beim Anlegen eines übermäßig starken und/oder eines vergleichsweise langen (gegebenenfalls auch eines mit mit einer hohen Duty-Cycle versehenen) Eingangssignals nicht beschädigt werden kann. Bei dem in Fig. 1 dargestellten Ausführungsbeispiel der Schaltungsanordnung 1 soll die Ventileinheit 4 lediglich zwischen einem offenen und einem geschlossenen Zustand hin und her geschaltet werden. Dementsprechend wird am Signaleingang 9 lediglich ein binäres Signal (mit geeigneter Spannung im Einschaltzustand) angelegt. Selbstverständlich ist es auch möglich, anders geartete elektrische Vorrichtungen im Zusammenhang mit der Schaltungsanordnung 1 vorzusehen und/oder auch Zwischenstellungen der elektrischen Vorrichtung (wobei es sich nicht notwendigerweise um eine Ventileinheit 4 handeln muss) zu realisieren.

Das über den Signaleingang 9 zugeführte Eingangssignal wird am nicht-invertierenden Eingang eines Operationsverstärkers 10 angelegt. Am invertierenden Eingang des Operationsverstärkers 10 wird die an einen Shunt-Widerstand 11 abfallende Spannung angelegt, die ein Maß für den durch die elektrische Spule 8 des Aktuators 5 hindurch fließenden Strom darstellt (Shunt-Widerstand 11 und elektrische Spule 8 bilden eine Spannungsteilerschaltung). In Abhängigkeit von der Differenz der beiden Eingangsspannungen am Operationsverstärker 10 ergibt sich eine Ausgangsspannung 21 mit zur Größe der Differenz korrespondierenden Spannungshöhe. Die Ausgangsspannung 21 des Operationsverstärkers 10 wird einem Analog-Digital-Wandler 12 zugeführt und digitalisiert. Der digitale Wert wird in einem Vergleichsregister 13 abgelegt. Das Vergleichsregister 13 steht mit einem Zählregister 14 in Verbindung, welches die Signale eines Zeittaktsignals 15 zählt. Je nach Vergleichsergebnis (also Zählregister 14 > Vergleichsregister 13 bzw. Zählregister 14 < Vergleichsregister 13 wird ein Flipflop 16 entsprechend ein- bzw. ausgeschaltet. Da das Zählregister 14 nur über eine endliche Länge verfügt, läuft das Zählregister 14 zu einem gewissen Zeitpunkt über, so dass es hierdurch wieder auf 0 gestellt wird. Zusätzlich oder optional ist es auch möglich, dass das Zählregister 14 durch Anlegen eines speziellen (Eingangs-) Signals auf 0 gestellt werden kann. Dabei kann es sich beispielsweise um einen Signal handeln, was über eine separate Eingangsleitung zugeführt wird (die in Fig 1 nicht dargestellt ist) und/oder welches ein dezidiertes Rückstell-Signal darstellt. Ebenso ist es aber auch (zusätzlich oder alternativ) denkbar, dass beispielsweise ein Nulldurchgang eines Spannungssignals (insbesondere ein Signalleitung 9 zugeführtes Spannungssignal) eine Rückstellung des Zählregisters 14 bewirkt (selbstverständlich kann anstelle eines Nulldurchgangs des Spannungssignals auch ein im Wesentlichen beliebiger anderer Wert gewählt werden). Schlussendlich ergibt sich somit am Ausgang des Flipflops 16 ein getaktetes, pulsweitenmoduliertes Steuersignal 17. Das pulsweitenmodulierte Steuersignal 17 steuert einen Schalttransistor 18 an, der den Stromkreis durch den Aktuator 5 an eine Spannungsquelle 19 anlegt, bzw. von dieser trennt. Aufgrund der Induktivität der elektrischen Spule 8 stellt sich somit in Kombination mit der Freilaufdiode 20 eine Stromstärke im Aktuator 5 ein, die zum Pulsweitenverhältnis (sogenannter Duty-Cycle) des pulsweitenmodulierten Steuersignals 17 korrespondiert.

Das pulsweitenmodulierte Steuersignal 17 wird jedoch nicht nur dem Schalttransistor 18 zugeführt, sondern auch einer elektronischen Auswerteeinheit 22. Basierend auf dem Pulsweitenverhältnis und/oder der Frequenz des pulsweitenmodulierten Steuersignals 17 errechnet diese die Stellung des Ventilkörpers 6. Insbesondere registriert die Auswerteelektronik 22 nicht nur den jeweiligen Absolutwert von Frequenz bzw. Pulsweitenverhältnis des pulsweitenmodulierten Steuersignals 17, sondern insbesondere auch sprungartige Veränderungen von Frequenz und/oder Pulsweitenverhältnis des pulsweitenmodulierten Steuersignals 17. Es sollte darauf hingewiesen werden, dass es durchaus auch möglich ist, das Ausgangssignal 21 des Operationsverstärkers 10 als Eingangssignal für die Auswerteeinheit 22 zu verwenden, da auch der durch die elektrische Spule 8 hindurch gehende Strom noch die Welligkeit des pulsweitenmodulierten Steuersignals 17 aufweist (wenn auch mit einer deutlich geringeren Intensität, wobei zusätzlich auch eine Gleichspannungskomponente überlagert ist). Insofern kann also auch das pulsweitenmodulierte Steuersignal 17 "zum Teil" genutzt werden.

In Fig. 2 ist eine zweite, bevorzugte Ausführungsmöglichkeit für eine Schaltanordnung 23 zur Ansteuerung einer Ventileinheit 4 dargestellt. Die Ventileinheit 4 ist dabei im vorliegend dargestellten Ausführungsbeispiel identisch zur in Fig. 1 dargestellten Ventileinheit 4. Selbstverständlich ist es möglich, dass die in Fig. 1 und 2 dargestellten Ventileinheiten 4 auch einen anderen Aufbau aufweisen, bzw. dass anstelle der Ventileinheit 4 auch eine völlig anders geartete elektrische Vorrichtung verwendet wird.

Ähnlich zum in Fig. 1 dargestellten Ausführungsbeispiel einer Schaltanordnung 1 wird auch beim vorliegend dargestellten Ausführungsbeispiel einer Schaltanordnung 23 die an einem Shunt-Widerstand 11 abfallende Spannung als Maß für den durch die elektrische Spule 8 hindurch fließenden Strom verwendet. Die am Shunt-Widerstand 11 abfallende Spannung wird zunächst in einem Vorverstärker 24 vorverstärkt. Das Ausgangssignal des Vorverstärkers 24 stellt somit das Ist-Signal 25 für einen Komparator 27 dar, der vorliegend softwaremäßig in einem Mikrocontroller implementiert ist. Die softwaremäßige Implementierung ist dabei so ausgeführt, dass der Komparator 27 eine Hysterese (was in Fig. 2 durch ein entsprechendes Symbol im Komparator-Schaltsymbol 27 dargestellt ist) aufweist. Weiterhin wird am vorliegend softwaremäßig ausgeführten Komparator 27 ein Sollwertsignal 26 angelegt. Basierend auf einem Vergleich von Sollwertsignal 26 und Ist-Signal 25 (unter Berücksichtigung einer zeitlichen Hysterese) wird ein Steuersignal 17 generiert, welches pulsweitenmoduliert ist. Die Modulation des pulsweitenmodulierten Steuersignals 17 ist dabei nicht nur "klassisch" im Hinblick auf das Pulsweitenverhältnis (Duty-Cycle) moduliert, sondern auch hinsichtlich seiner Frequenz.

Um die Eingangssignale (Sollwertsignal 26 und Ist-Signal 25) numerischprogrammtechnisch verarbeiten zu können, weist der Komparator 27 - soweit erforderlich - an seinen Eingängen Analog-Digital-Wandler auf. Im in Fig. 2 dargestellten Ausführungsbeispiel liegt das Sollwertsignal 26 bereits in digitaler Form vor. Dementsprechend weist der entsprechende Eingang des Komparators 27 keinen Analog-Digital-Wandler auf. Daher muss nur das vom Vorverstärker 24 stammende Analog-Signal in eine digitale Form überführt werden. Gegebenenfalls kann es sich auch als vorteilhaft erweisen, wenn die Wandlung von analoger auf digitale Form bereits in oder unmittelbar hinter dem Vorverstärker 24 erfolgt. Dementsprechend ist dann im Komparator 27 kein Analog-Digital-Wandler mehr erforderlich.

Analog zum in Fig. 1 dargestellten Ausführungsbeispiel einer Schaltungsanordnung 1 weist auch die in Fig. 2 dargestellte Schaltungsanordnung 23 eine Auswerteinheit 22 auf, die basierend auf der Frequenz und/oder dem Pulsweitenverhältnis des Steuersignals 17 auf die aktuelle Stellung des Ventilkörpers 6 schließt. Gleichzeitig wird das Steuersignal 17 an den Eingang eines Schalttransistors 8 gelegt, sodass hierdurch der durch den Aktuator 5 fließende Strom entsprechend geregelt wird. Auch eine Spannungsquelle 19 sowie eine Freilaufdiode 20 ist analog zum in Fig. 1 dargestellten Ausführungsbeispiel vorgesehen.

Der Vorteil der in Fig. 2 dargestellten softwaremäßigen Ausführung des Komparators 27 liegt darin, dass im Komparator 27 eine größere Menge an Informationen vorhanden ist. Insofern können mehrere Eigenschaften von Sollwertsignal 26 und Ist-Signal 25 verarbeitet werden. Auch ist eine Veränderung der Höhe des Sollwertsignals 26 sehr einfach möglich, beispielsweise um Drift-Erscheinungen beim Dauerbetrieb der Ventileinheit 4 auszugleichen. Hierzu kann einfach der Wert einer entsprechenden Variablen geändert werden.

Im Übrigen ist es auch möglich, dass bestimmte, vom Komparator 27 ermittelte Eigenschaften von Sollwertsignal 26 und/oder Ist-Signal 25 in digitaler Form der Auswerteeinheit 22 zugeführt werden, sodass gegebenenfalls in der Auswerteeinheit 22 ein genaueres Ergebnis ermittelt werden kann. Hierzu kann eine Datenleitung zwischen Komparator 27 und Auswerteeinheit 22 vorgesehen werden (vorliegend nicht dargestellt). Auch ist es möglich, dass Auswerteeinheit 22 und Komparator 27 beispielsweise als softwaremäßige Module auf einer einzelnen Hardwareeinheit (beispielsweise auf einem Einplatinen-Computer oder einem Mikrocontroller) ausgeführt werden.

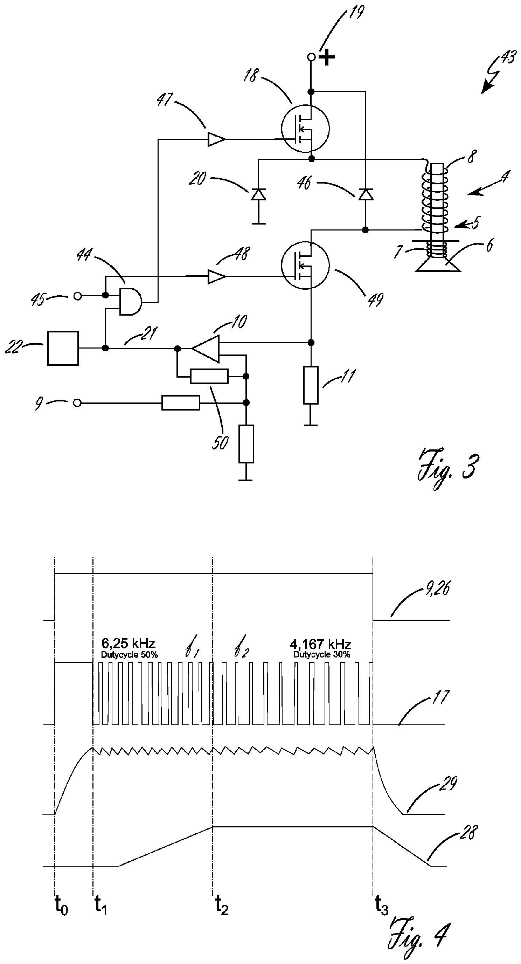

In Fig. 3 ist ein drittes, besonders bevorzugtes Ausführungsbeispiel für eine Schaltungsanordnung 43 zur Ansteuerung einer Ventileinheit 4 dargestellt. Die in Fig. 3 dargestellte Schaltungsanordnung 43 ähnelt in weiten Teilen den in den Fig. 1 und 2 dargestellten Schaltungsanordnungen 1, 23, insbesondere der in Fig. 1 dargestellten Schaltungsanordnung 1. Bauteile beziehungsweise Baugruppen, die eine gleichartige Funktion und/oder einen gleichartigen Aufbau aufweisen werden zur Vermeidung von unnötigen Wiederholungen mit gleichartigen Bezugszeichen versehen und nicht nochmals eingehend beschrieben.

Ein wesentlicher Unterschied zwischen den bislang beschriebenen Schaltungsanordnungen 1, 23 und der vorliegend dargestellten Schaltungsanordnung 43 besteht darin, dass insbesondere auf Standard-Komponenten 18, 44, 46, 47, 48, 49 zurückgegriffen wird, die als Hardware-ausgeführte Bauteile beziehungsweise Baugruppen ausgebildet sind. Es wird also (abgesehen von der Auswerteeinheit 22) nicht auf eine Software-Steuerung zurückgegriffen.

Die Schaltungsanordnung 43 weist zwei Steuereingänge 9, 45 auf, nämlich einen Signaleingang 9 und einen Logikeingang 45 (Signal-Flag-Eingang) auf. Über den Logikeingang 45 kann der Aktuator 5 mithilfe eines binären Signals ein- beziehungsweise ausgeschaltet werden. Zusätzlich kann über den Signaleingang 9 eine Referenzspannung angelegt werden, mit der der Maximalsollwert des durch die elektrische Spule 8 des Aktuators 5 fließenden elektrischen Stroms eingestellt werden kann. Dadurch, dass im vorliegend dargestellten Ausführungsbeispiel die Referenzspannung nicht ein- und ausgeschaltet werden muss, kann die Schaltung zur Erzeugung der Referenzspannung besonders einfach ausfallen. Der Logikeingang 45 kann beispielsweise durch eine elektronische Steuerschaltung (einen so genannten Controller; vorliegend nicht dargestellt) angesteuert werden. Selbstverständlich ist es möglich, dass die elektronische Steuerschaltung zur Erzeugung eines Signals für den Logikeingang 45 auf Ausgabewerte der Auswerteeinheit 22 zurückgreift.

Wird bei der Schaltungsanordnung 43 ein Signal an den Logikeingang 45 angelegt (welches vorliegend bewirkt, dass die an den Aktuator 5 befestigte Ventileinheit 4 schließt), so wird einerseits der zweite Schalttransistor 49 über die zweite Verstärkerschaltung 48 auf "durchlässig" geschaltet. Der zweite Schalttransistor 48 verbleibt in einem durchgeschalteten Zustand, solange am Logikeingang 45 ein Signal anliegt. Die eigentliche Regelungsaufgabe, also die Steuerung der Stromstärke, die durch die elektrische Spule 8 des Aktuators 5 hindurch fließt, wird demgegenüber durch den ersten Schalttransistor 18 realisiert (wie im Folgenden näher beschrieben).

Weiterhin bewirkt das Signal am Logikeingang 45, dass der UND-Logikschaltkreis 44 für das Ausgangssignal 21 des Operationsverstärkers 10 "durchgeschaltet" wird. Das Ausgangssignal 21 des Operationsverstärkers 10 bewirkt somit mithilfe des ersten Vorverstärkers 47 ein Einschalten beziehungsweise Ausschalten des ersten Schalttransistors 18, und damit eine Freigegabe beziehungsweise ein Sperren des durch die elektrischen Spule 8 des Aktuators 5 fließenden elektrischen Stroms.

Unmittelbar nach dem Anlegen des Signals am Logikeingang 45 schaltet der erste Schalttransistor 18 zunächst auf "durchlässig" (der zweite Schalttransistor 49 ist ebenfalls auf "durchlässig" geschaltet). Die Stromstärke durch die elektrische Spule 8 des Aktuators 5 nimmt stetig zu. Dementsprechend nimmt die Spannung am Shunt-Widerstand 11 zu. Die dort abgegriffene elektrische Spannung wird dem invertierenden Eingang des Operationsverstärkers 10 zugeführt. Bei einer gewissen Stromstärke überschreitet die am Shunt-Widerstand 11 abgegriffene Spannung die über den Signaleingang 9 zugeführte Referenzspannung, die dem nicht-invertierenden Eingang des Operationsverstärkers 10 zugeführt wird. Dies bewirkt, dass das Ausgangssignal 21 des Operationsverstärkers 10 abfällt, und somit der erste Schalttransistor 18 sperrt. Aufgrund der Induktivität der elektrischen Spule 8 wird der elektrische Strom durch die elektrische Spule 8 zunächst aufrechterhalten (Stromfluss durch erste Freilaufdiode 20 und den zweiten Schalttransistor 49), jedoch mit schnell abnehmender Stromstärke. Dies bewirkt ein Absinken der am Shunt-Widerstand 11 abfallenden Spannung, so dass der Operationsverstärker 10 erneut umschaltet, und ein Ausgangssignal 21 ausgibt. Die "Schnelligkeit" der Umschaltung zwischen den beiden Schaltzuständen des Operationsverstärkers 10 wird durch die Hysterese des Operationsverstärkers 10 bestimmt, die wesentlich durch die Größe des Rückkopplungswiderstands 50 beeinflusst wird. Die äußere Beschaltung des Operationsverstärkers 10 ist darüber hinaus vorliegend so gewählt, dass es sich bei dem Ausgangssignal 21 im Wesentlichen um ein binäres Signal handelt. Das Ausgangssignal 21 kennt somit im Wesentlichen lediglich die beiden Zustände "an" und "aus".

Auf diese Weise wird ein Stromfluss mit vorgegebener Soll-Stromstärke (die Höhe der Stromstärke wird durch den Signaleingang 9 vorgegeben) durch den Aktuator 5 bewirkt. Der Stromfluss weist dabei gewisse Schwankungen um die eigentliche Soll-Stromstärke auf.

Wie bereits erwähnt (und im Folgenden noch näher erläutert) kann von der Frequenz und dem Duty-Cycle des Ausgangssignals 21 des Operationsverstärkers 10 auf den Schaltzustand der Ventileinheit 4 geschlossen werden. Dementsprechend wird das Ausgangssignal 21 nicht nur zur Rückkopplung verwendet, sondern zusätzlich einer Auswerteeinheit 22 zugeführt. Die von dieser Auswerteeinheit 23 gewonnenen Informationen können im Übrigen auch zu Rückkopplungszwecken verwendet werden (beispielsweise zur zeitlichen Variation eines Ansteuersignals, um beispielsweise eine Drift durch Verschleiß oder Temperaturdriften auszugleichen).

Soll zu einem späteren Zeitpunkt die Ventileinheit 4 wieder geöffnet werden, so wird das am Logikeingang 45 anliegende Signal abgeschaltet. Dieses bewirkt, dass sowohl der erste Schalttransistor 18 (über den UND-Logikschaltkreis 44), als auch der zweite Schalttransistor 49 gesperrt werden. Die Induktivität der elektrischen Spule 8, die zunächst versucht, den Stromdurchfluss aufrecht zu erhalten, "pumpt" nunmehr über die erste Freilaufdiode 20 und die zweite Freilaufdiode 46 elektrischen Strom vom Erdpotenzial auf das (vergleichsweise hohe) Spannungspotenzial der Spannungsquelle 19. Dies bewirkt ein besonders rasches Abklingen der Stromstärke - und damit ein besonders rasches Öffnen des Ventilkörpers 6. Durch die Bauform mit zwei Schalttransistoren 19, 49 wird somit eine Schnellabschalt-Funktionalität erzielt.

Lediglich der Vollständigkeit halber wird darauf hingewiesen, dass es durchaus möglich ist, die Schaltungsanordnung 43 auch ohne zweiten Schalttransistor 49 (und ohne zweite Verstärkerschaltung 48) auszuführen. Der Stromdurchfluss durch die elektrische Spule 8 des Aktuators 5 klingt dann jedoch langsamer ab; mithin ist keine gleichwertig gute Schnellabschalt-Funktionalität realisiert.

In Fig. 4 ist der zeitliche Ablauf unterschiedlicher Signale bei einer Ansteuerung einer Ventileinheit 4 unter Verwendung einer Schaltungsanordnung 1 gemäß Fig. 1, einer Schaltungsanordnung 23 gemäß Fig. 2 oder einer Schaltungsanordnung 43 gemäß Fig. 3 (wobei auch weitere Schaltungsanordnungen denkbar sind) dargestellt. Zum Zeitpunkt t₀ wird ein Eingangssignal 9, 26 mit entsprechender Höhe angelegt. Das Ventil 4 befindet sich zu diesem Zeitpunkt noch in einem beispielsweise geöffneten Zustand (in Fig. 4 durch die Ventilpositionskurve 28 dargestellt). Die Steuereinheit 2 schaltet das Steuersignal 17 zunächst auf einen "dauerhaft" eingeschalteten Wert. Aufgrund der Induktivität der elektrischen Spule 8 dauert es eine gewisse Zeit, bis der Strom 29 durch die Spule 8 ansteigt und dem Steuersignal 17 folgt.

Zum Zeitpunkt t₁ ist die maximal zulässige Stromstärke 29 durch die elektrische Spule 8 erreicht. Dementsprechend ändert die Steuereinheit 2 das Steuersignal 17 auf ein pulsweitenmoduliertes Signal mit einer bestimmten Schaltfrequenz und einem bestimmten Schaltverhältnis (einem bestimmten "Duty-Cycle"). Dies hat zur Folge, dass der Strom 29 durch die elektrische Spule 8 (abgesehen von einer Restwelligkeit) annähernd konstant bleibt. Wie man weiterhin Fig. 4 entnehmen kann (insbesondere der Ventilpositionskurve 28) hat der Ventilkörper 6 begonnen, sich zu bewegen. Die Ventileinheit 4 ist jedoch noch nicht geschlossen; der Ventilkörper 6 ist dementsprechend noch in Bewegung.

Zum Zeitpunkt t₂ ist die Ventileinheit 4 gerade eben vollständig geschlossen. (Es ist natürlich auch möglich, dass die "Schaltungslogik" der Ventileinheit 4 anders gestaltet ist. Wenn es sich beispielsweise um eine Ventileinheit 4 handelt, die durch einen Stromimpuls geöffnet wird, so ist die Ventileinheit 4 zum Zeitpunkt t₂ gerade eben vollständig geöffnet. Die anderen Positionen sind in entsprechender Weise zu dem vorliegend beschriebenen Ausführungsbeispiel "vertauscht".) Dies ist am Knick in der Ventilpositionskurve 28 gut zu erkennen. Die Erfinder haben nun festgestellt, dass dieses Erreichen der Endposition des Ventilkörpers 4 eine deutliche Veränderung des von der Steuereinheit 2 erzeugten Steuersignals 17 zur Folge hat. Erste Messungen haben ergeben, dass sich sowohl die Frequenz, als auch das Pulsweitenverhältnis des Steuersignals signifikant ändern. Dies ist in Fig. 4 an der veränderten Form des Steuersignals 17 selbst zu erkennen. Weiterhin ist in Fig. 4 gut zu erkennen, dass sich auch der zeitliche Verlauf des Stroms 29 durch die elektrische Spule 8 ändert (insbesondere die Frequenz der Restwelligkeit ändert sich signifikant). Dementsprechend kann auch das Stromsignal 29 für eine Positionsauswertung des Ventilkörpers 6 oder dergleichen genutzt werden.

Solange das Eingangssignal 9, 26 eingeschaltet bleibt, verändert sich an der Situation nichts. Die Stromstärke 29 durch die Ventileinheit 4 bleibt konstant, das Steuersignal 17 ändert sich nicht, und auch die Position des Ventilkörpers 6 bleibt konstant (siehe Ventilpositionskurve 28). Erst wenn das Eingangssignal 9, 26 wieder abgeschaltet wird (zum Zeitpunkt t₃), wird das Steuersignal 17 für den Schalttransistor 18 "dauerhaft" abgeschaltet, der Strom 29 durch die elektrische Spule 8 nimmt ab und der Ventilkörper 6 der Ventileinheit 4 bewegt sich in seine Ausgangsstellung zurück (siehe Ventilpositionskurve 28).

Beim in Fig. 4 dargestellten Versuchsaufbau hat sich in ersten Versuchen eine Änderung der Frequenz des Steuersignals 17 von 6,25 KHz (Ventilkörper 6 ist noch in Bewegung) auf eine Frequenz von 4,517 KHz (Ventilkörper 6 nicht mehr in Bewegung; Ventileinheit 4 vollständig geschlossen) ergeben. Auch das Pulsweitenverhältnis (der Duty-Cycle) hat sich in diesen Versuchen signifikant verändert. So sprang das Pulsweitenverhältnis innerhalb einer sehr kurzen Zeitspanne von zunächst 50 % auf anschließend 30 %.

Es ist somit klar ersichtlich, dass sowohl das Steuersignal 17, als auch der eigentliche Strom 29 durch die elektrische Spule 8 ein sehr gutes Eingangssignal für eine Auswerteeinheit 22 darstellen.

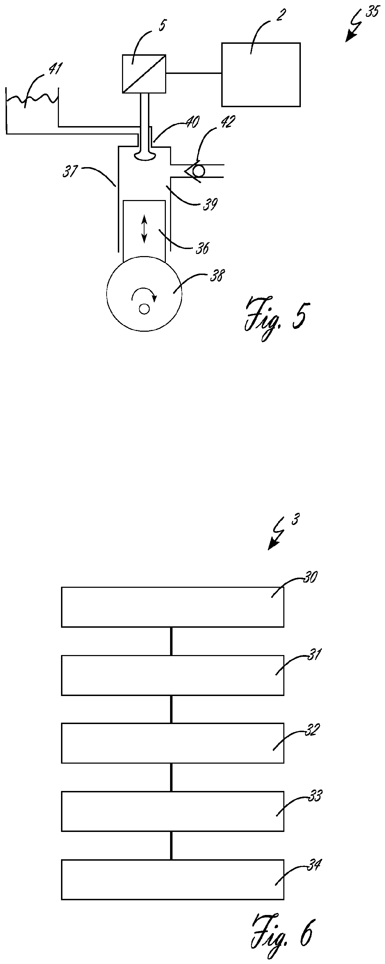

In Fig. 5 ist schließlich noch in einer schematisch stark vereinfachten Darstellung eine elektrisch kommutierte Hydraulikpumpe 35 dargestellt. Die elektrisch kommutierte Hydraulikpumpe 35 weist einen Kolben 36 auf, der unter Vermittlung einer exzentrisch angeordneten Antriebsscheibe 38 in einem Zylinder 37 auf und ab bewegt wird (die Abwärtsbewegung kann beispielsweise durch eine Rückstellfeder, die vorliegend nicht dargestellt ist, erfolgen). Dementsprechend wird die in Zylinder 37 befindliche Kavität 39 zyklisch vergrößert beziehungsweise verkleinert.

Vergrößert sich die Kavität 39 durch eine Abwärtsbewegung des Kolbens 36, so wird Hydrauliköl durch ein elektrisch gesteuertes Eingangsventil 40 hindurch aus einem Reservoir 41 heraus angesaugt. Bei dem elektrisch gesteuerten Eingangsventil 40 kann es sich beispielsweise um die in Fig. 1 oder Fig. 2 gezeigte Ventileinheit 4 handeln.

Hat der Kolben 36 seinen unteren Totpunkt erreicht beziehungsweise überschritten, so bewegt er sich erneut aufwärts (in den Zylinder 37 hinein) und verkleinert dementsprechend die Kavität 39. Das in der Kavität 39 befindliche Hydrauliköl wird zunächst über das nach wie vor geöffnete Eingangsventil 40 zurück ins Reservoir 41 gedrückt. Somit wird kein Hydrauliköl effektiv gepumpt.

Die Situation ändert sich jedoch, wenn das Eingangsventil 40 durch einen entsprechenden Steuerimpuls geschlossen wird. Das Hydrauliköl kann nunmehr nicht mehr über das Eingangsventil 40 abströmen. Demzufolge verlässt das Hydrauliköl die Kavität 39 nunmehr über einen einfaches Einwegeventil 42 in Richtung eines (vorliegend nicht näher dargestellten) Hochdruckreservoirs.

Der große Unterschied zwischen einer elektrisch kommutierten Hydraulikpumpe 35 und einer klassischen Hydraulikpumpe mit passiven Eingangs- und Ausgangsventilen besteht darin, dass das Schließen des Eingangsventils 40 mithilfe des Aktuators 5 zu einem beliebigen Zeitpunkt veranlasst werden kann. Dadurch ist es möglich, von einem Pumpzyklus zum nächsten die effektiv gepumpte Menge an Hydrauliköl in weiten Bereichen zu verändern.

Das Eingangsventil 40 (was, wie bereits erwähnt, beispielsweise entsprechend einer in Fig. 1 oder Fig. 2 dargestellten Ventileinheit 4 ausgebildet sein kann) wird über einen Aktuator 5 geschlossen und gegebenenfalls auch geöffnet (wobei es möglich ist, dass der Öffnungsvorgang durch einen Druckunterschied des an beiden Seiten des Eingangsventils 40 befindlichen Hydrauliköls erfolgt). Die Ansteuerung des Aktuators 5 (und damit des Eingangsventils 40) erfolgt insbesondere unter Verwendung einer Steuereinheit 2, wie sie in Fig. 1 oder Fig. 2 dargestellt ist.

In Fig. 6 ist nochmals in schematischer Form ein Ablaufdiagramm 3 dargestellt, welches den Verfahrensablauf des vorgeschlagenen Verfahrens schematisch darstellt. In einem ersten Schritt 30 wir ein Eingangssignal (beispielsweise ein Eingangssignal 9, 26; siehe Fig. 1 und 2) eingelesen.

Dieses eingelesene Eingangssignal 9, 26 (Sollwertsignal 26) wird in einem anschließenden Schritt 31 mit dem Ist-Signal 25 verglichen, welches von der elektrischen Vorrichtung (beispielsweise von einer Ventileinheit 4) geliefert wird. Basierend auf dem Soll-Ist-Vergleich 31 erfolgt (beispielsweise in einer Steuereinheit 2) die Berechnung 32 eines geeigneten Steuersignals (z. Bsp. Steuersignal 17), mit dem die elektrische Vorrichtung angesteuert werden soll.

Das bei der Berechnung 32 ermittelte Steuersignal dient nicht nur zur Ansteuerung der elektrischen Vorrichtung 4, sondern wird zusätzlich (beispielsweise gleichzeitig) dazu verwendet, ein Zustandssignal zu berechnen 33. Beispielsweise kann es sich bei dem derart berechneten 33 Zustandssignal um ein Signal handeln, dass die elektrische Vorrichtung 4 eine bestimmte Position eingenommen hat (z. Bsp. Endposition).

Die in diesem Schritt 33 gewonnen Zustandssignale können anschließend in einem weiteren Verfahrensschritt 34 beispielsweise zu einer Nachjustage verwendet werden. So kommt es beispielsweise häufiger vor, dass manche mechanischen, elektrischen oder sonstigen technischen Komponenten im Laufe der Zeit eine gewisse Drift aufweisen. Einer derartigen Drift kann jedoch durch die Nachjustage im Schritt 34 wirksam entgegen gewirkt werden. Als ein bevorzugtes Beispiel ist in diesem Zusammenhang beispielsweise eine Änderung der Vorhaltezeit für die nächste Ventilbewegung (den nächsten "Schuss") zu nennen.

**Bezugszeichenliste**

| | |
|---|---|
| 1. Schaltungsanordnung | 27. Komparator |
| 2. Steuereinheit | 28. Ventilpositionskurve |
| 3. Ablaufdiagramm | 29. Strom |
| 4. Ventileinheit | 30.Aufnahmeeingangssignal |
| 5. Aktuator | 31. Vergleich Soll-Ist-Wert |
| 6. Ventilkörper | 32. Berechnung Steuersignal |
| 7. Rückstellfeder | 33. Bestimmung Zustand |
| 8. Elektrische Spule | 34. Nachjustageschritt |
| 9. Signaleingang | 35. elektrisch kommutierte Hydraulikpumpe |
| 10. Operationsverstärker | |
| 11. Shunt-Widerstand | 36.Kolben |
| 12. Analog-Digital-Wandler | 37.Zylinder |
| 13. Vergleichsregister | 38. Antriebsscheibe |
| 14. Zählerregister | 39. Kavität |
| 15. Zeittaktsignal | 40. Eingangsventil |
| 16. Flipflop | 41. Reservoir |
| 17. Steuersignal | 42. Einwegeventil |
| 18. Schalttransistor | 43. Schaltungsanordnung |
| 19. Spannungsquelle | 44. UND-Logikschaltkreis |
| 20. Freilaufdiode | 45. Logikeingang |
| 21. Ausgangssignal | 46. zweite Freilaufdiode |
| 22. Auswerteeinheit | 47. erste Verstärkerschaltung |
| 23. Schaltungsanordnung | 48. zweite Verstärkerschaltung |
| 24. Vorverstärker | 49. zweiter Schalttransistor |
| 25. Ist-Signal | 50.Rückkopplungs-Widerstand |
| 26. Sollwertsignal | |

## Patentansprüche

1. Verfahren (3) zur Ermittlung (33) zumindest eines Zustandskennwerts (28) einer zumindest zeitweise und/oder zumindest teilweise mit einem zeitlich variierenden Steuersignal (17) angesteuerten elektrischen Vorrichtung (4), **dadurch gekennzeichnet, dass** der zumindest eine Zustandskennwert (28) zumindest zeitweise und/oder zumindest teilweise sowohl unter Verwendung der Frequenz des zeitlich variierenden Steuersignals (17) als auch dem Schaltverhältnis des zeitlich variierenden Steuersignals (17) ermittelt wird.

2. Verfahren (3) nach Anspruch 1, **dadurch gekennzeichnet, dass** es sich bei dem zeitlich variierenden Steuersignal (17) zumindest zeitweise und/oder zumindest teilweise um ein pulsartiges Steuersignal (17) und/oder um ein zyklisches Steuersignal (17), insbesondere um ein pulsweitenmodulationsartiges Steuersignal (17) und/oder ein rechteckartiges Steuersignal (17) handelt.

3. Verfahren (3) nach Anspruch 1 oder 2, **dadurch gekennzeichnet, dass** es sich bei der elektrischen Vorrichtung (4) zumindest zeitweise und/oder zumindest teilweise um eine, eine Induktionseinrichtung (8) aufweisende elektrische Vorrichtung (4), insbesondere um eine Elektromotoreinrichtung, um eine elektrische Spuleneinrichtung (8) und/oder um eine Aktuatoreinrichtung (5), bevorzugt um eine Aktuatoreinrichtung (5) für eine Ventileinrichtung (6), handelt.

4. Verfahren (3) nach einem der vorangehenden Ansprüche, insbesondere nach Anspruch 3, **dadurch gekennzeichnet, dass** die elektrische Vorrichtung (4) zumindest zeitweise und/oder zumindest bereichsweise nicht-quasi-stationär und/oder nicht-stationär betrieben wird.

5. Verfahren (3) nach einem der vorangehenden Ansprüche, **dadurch gekennzeichnet, dass** der zumindest eine Zustandskennwert (28) zumindest zeitweise und/oder zumindest teilweise ein Maß für eine Position (28) von zumindest Teilen der elektrischen Vorrichtung (4), ein Maß für das Erreichen bestimmter, insbesondere ausgezeichneter Positionen (28) von zumindest Teilen der elektrischen Vorrichtung (4), ein Maß für die Geschwindigkeit von zumindest Teilen der elektrischen Vorrichtung (4) und/oder ein Maß für das Eintreten zumindest eines Fehlerereignisses darstellt.

6. Verfahren (3) nach einem der vorangehenden Ansprüche, **dadurch gekennzeichnet, dass** die elektrische Vorrichtung (4) zumindest zeitweise und/oder zumindest teilweise mit einem Maximalstrombegrenzungsverfahren (17) angesteuert wird.

7. Verfahren (3) nach einem der vorangehenden Ansprüche, insbesondere nach Anspruch 3 oder 4, **dadurch gekennzeichnet, dass** zumindest eine mit dem zeitlich variierenden Steuersignal (17) angesteuerte elektrische Vorrichtung (4) zumindest zeitweise und/oder zumindest bereichsweise für eine zumindest teilweise elektrisch kommutierte Hydraulikpumpe und/oder für einen zumindest teilweise elektrisch kommutierten Hydraulikmotor verwendet wird.

8. Verfahren (3) nach einem der vorangehenden Ansprüche, **dadurch gekennzeichnet, dass** der zumindest eine Zustandskennwert (28) zumindest zeitweise und/oder zumindest teilweise durch eine Messung des Absolutwerts der Schaltfrequenz des zeitlich variierenden Steuersignals (17) und/oder durch eine Messung einer Änderung der Schaltfrequenz des zeitlich variierenden Steuersignals (17) und/oder durch eine Messung des Absolutwerts des Schaltverhältnisses des zeitlich variierenden Steuersignals (17) und/oder durch eine Messung einer Änderung des Schaltverhältnisses des zeitlich variierenden Steuersignals (17) ermittelt wird.

9. Elektrische Steuervorrichtung (2) zur zumindest zeitweisen und/oder zumindest teilweisen Ermittlung (32) zumindest eines Zustandskennwerts (28) einer mit einem zeitlich variierenden Steuersignal (17) angesteuerten elektrischen Vorrichtung (4), welche derart ausgebildet und eingerichtet ist, dass sie zumindest zeitweise und/oder zumindest teilweise ein Verfahren (3) nach einem der Ansprüche 1 bis 8 durchführt.

10. Elektrische Steuervorrichtung (2) nach Anspruch 9, **dadurch gekennzeichnet, dass** sie zumindest teilweise als elektronische Steuervorrichtung (10, 13, 14, 16, 22, 27), insbesondere zumindest teilweise als programmgesteuerte Computereinrichtung (13, 14, 22, 27) ausgebildet ist.

11. Elektrisch kommutierte Hydraulikpumpe und/oder elektrisch kommutierter Hydraulikmotor, **dadurch gekennzeichnet, dass** diese(r) zumindest zeitweise und/oder zumindest teilweise unter Verwendung eines Verfahrens (3) nach einem der Ansprüche 1 bis 8 angesteuert wird und dadurch, dass diese(r) zumindest eine elektrische Steuervorrichtung (2) nach Anspruch 9 oder 10 aufweist.

## Claims

1. Method (3) for determining (33) at least one characterising value (28) of the condition of an electric device (4) that is actuated at least at times and/or at least in part with an actuating signal (17) that is varying with time, **characterised in that** the at least one characterising value (28) of the condition is determined at least at times and/or at least in part using both the frequency of the actuating signal (17) that is varying in time, and the duty cycle of the actuating signal (17) that is varying with time.

2. Method (3) according to claim 1, **characterised in that** the actuating signal (17) that is varying with time is at least at times and/or at least in part a pulse-like actuating signal (17) and/or a cyclic actuating signal (17), in particular a pulse width modulated actuating signal and/or a rectangular-like actuating signal (17).

3. Method (3) according to claim 1 or 2, **characterised in that** the electric device (4) is at least at times and/or at least in part an electric device (4), comprising an induction means (8), in particular an electric motor device, an electric coil device (8) and/or an actuating device (5), preferably an actuating device (5) for a valve unit (6).

4. Method (3) according to any of the preceding claims, in particular according to claim 3, **characterised in that** the electric device (4) is used at least at times and/or at least in part non-quasi-stationary and/or non-stationary.

5. Method (3) according to any of the preceding claims, **characterised in that** the at least one characterising value (28) of the condition is at least at times and/or at least in part a measure for a position (28) of at least parts of the electric device (4), a measure for reaching certain, in particular distinguished positions (28) of at least parts of the electric device (4), a measure for the speed of at least parts of the electric device (4) and/or a measure for at least one fault condition that is occurring.

6. Method (3) according to any of the preceding claims, **characterised in that** the electric device (4) is at least at times and/or at least in part actuated using a a maximum current limitation method (17).

7. Method (3) according to any of the preceding claims, in particular according to claim 3 or 4, **characterised in that** at least an electric device (4) that is actuated with the actuating signal (17) that is varying with time is used at least at times and/or at least in part for a hydraulic pump that is at least in part electrically commutated and/or for a hydraulic motor that is at least in part electrically commutated.

8. Method (3) according to any of the preceding claims, **characterised in that** the at least one characterising value (28) of a condition is at least at times and/or at least in part determined by measuring the absolute value of the switching frequency of the actuating signal (17) that is varying with time and/or by measuring a change of the switching frequency of the actuating signal (17) that is varying with time and/or by measuring the absolute value of the duty cycle of the actuating signal (17) that is varying with time and/or by measuring a change of the duty cycle of the actuating signal (17) that is varying with time.

9. Electric control device (2) for determining (32) at least at times and/or at least in part the characterising value (28) of the condition of an electric device (4) that is actuated by an actuating signal (17) that is varying with time, wherein the electronic controlling device (2) is designed and arranged in a way that it performs at least in part and/or at least at times a method (3) according to any one of claims 1 to 8.

10. Electric control device (2) according to claim 9, **characterised in that** it is designed at least in part as an electronic controller device (10, 13, 14, 16, 22, 27), in particular at least in part as a program controlled computer device (13, 14, 22, 27).

11. Electrically commutated hydraulic pump and/or electrically commutated hydraulic motor, **characterised in that** it is at least at times and/or at least in part actuated using a method (3) according to any one of claims 1 to 8, and **in that** it comprises at least an electric control device (2) according to claim 9 or 10.

## Revendications

1. Procédé (3) pour la détermination (33) d'au moins une valeur caractéristique d'état (28) d'un appareil électrique (4) qui est actionné au moins temporairement et/ou au moins partiellement avec un signal de commande (17) variant dans le temps, **caractérisé en ce que** l'au moins une valeur caractéristique d'état (28) est déterminée au moins temporairement et/ou au moins partiellement aussi bien par l'utilisation de la fréquence du signal de commande (17) variant dans le temps que par l'utilisation du rapport de commutation du signal de commande variant dans le temps (17).

2. Procédé (3) selon la revendication 1, **caractérisé en ce que** le signal de commande (17) variant dans le temps est au moins temporairement et/ou au moins partiellement un signal de commande (17) en forme d'impulsion et/ou un signal de commande (17) cyclique, en particulier un signal de commande (17) en modulation de largeur d'impulsion et/ou un signal de commande (17) rectangulaire.

3. Procédé (3) selon la revendication 1 ou 2, **caractérisé en ce que** le dispositif électrique (4) est au moins temporairement et/ou au moins partiellement un dispositif électrique (4) comportant une unité d'induction (8), en particulier une unité à moteur électrique, une unité à bobine électrique (8) et/ou une unité d'actionnement (5), de préférence une unité d'actionnement (5) pour une unité à vanne (6).

4. Procédé (3) selon l'une des revendications précédentes, en particulier selon la revendication 3, **caractérisé en ce que** le dispositif électrique (4) est utilisé au moins temporairement et/ou au moins en partie non quasi-stationnaire et/ou non stationnaire.

5. Procédé (3) selon l'une des revendications précédentes, **caractérisé en ce que** l'au moins une valeur caractéristique d'état (28) représente au moins temporairement et/ou au moins partiellement une mesure d'une position (28) d'au moins des parties du dispositif électrique (4), une mesure de l'atteinte de certaines positions (28), en particulier désignées, d'au moins des parties du dispositif électrique (4), une mesure de la vitesse d'au moins des parties du dispositif électrique (4) et/ou une mesure de la survenue d'au moins une condition de défaut.

6. Procédé (3) selon l'une des revendications précédentes, **caractérisé en ce que** le dispositif électrique (4) est actionné au moins temporairement et/ou au moins partiellement avec un procédé de limitation de courant maximum (17).

7. Procédé (3) selon l'une des revendications précédentes, en particulier selon la revendication 3 ou 4, **caractérisé en ce qu'**au moins un dispositif électrique (4) actionné par le signal de commande (17) variable dans le temps est utilisé au moins temporairement et/ou au moins en partie pour une pompe hydraulique au moins partiellement à commutation électrique et/ou pour un moteur hydraulique au moins partiellement à commutation électrique.

8. Procédé (3) selon l'une des revendications précédentes, **caractérisé en ce que** l'au moins une valeur caractéristique d'état (28) est déterminée au moins temporairement et/ou au moins partiellement par une mesure de la valeur absolue de la fréquence de commutation du signal de commande variable dans le temps (17) et/ou par une mesure d'une variation de la fréquence de commutation du signal de commande variable dans le temps (17) et/ou par une mesure de la valeur absolue du rapport de commutation du signal de commande variable dans le temps (17) et/ou par une mesure d'une variation du rapport de commutation du signal de commande variable dans le temps (17).

9. Dispositif de commande électrique (2) pour déterminer au moins temporairement et/ou au moins partiellement (32) au moins une valeur caractéristique d'état (28) d'un dispositif électrique (4) actionné par un signal de commande (17) variant dans le temps et qui est conçu et configuré de manière à exécuter au moins temporairement et/ou au moins partiellement un procédé (3) selon une des revendications 1 à 8.

10. Dispositif de commande électrique (2) selon la revendication 9, **caractérisé en ce qu'**il est conçu au moins partiellement comme dispositif de commande électronique (10, 13, 14, 16, 22, 27), en particulier au moins partiellement comme unité informatique commandée par programme (13, 14, 22, 27) .

11. Pompe hydraulique à commutation électrique et/ou moteur hydraulique à commutation électrique, caractérisé(e) en ce que celle-ci/celui-ci est commandé(e) au moins temporairement et/ou au moins partiellement par l'utilisation d'un procédé (3) selon l'une des revendications 1 à 8 et en ce que celle-ci/celui-ci comporte au moins un dispositif de commande électrique (2) selon la revendications 9 ou 10.
